# EUROPEAN PATENT APPLICATION

(11) **EP 4 465 792 A1**
(43) Date of publication of application: **20.11.2024**
(21) Application number: 24162899.9
(22) Date of filing: 12.03.2024
(51) Int. Cl.: H10K 59/121, H10K 59/126, H10K 59/131, H10K 59/35, H10K 59/40, H10K 59/65, H10K 59/80, H10K 50/828, H10K 102/00

(54) **DISPLAY PANEL AND DISPLAY APPARATUS**

(30) Priority: 16.05.2023 KR 20230062988; 31.05.2023 KR 20230070420
(71) Applicant: Samsung Display Co., Ltd., Yongin-si, Gyeonggi-do 17113 (KR)
(72) Inventor: LHEE, Zail, 17113 Yongin-si (KR); KIM, Swaehyun, 17113 Yongin-si (KR); SEON, Jongbaek, 17113 Yongin-si (KR); JANG, Hyejin, 17113 Yongin-si (KR); KIM, Deokhoi, 17113 Yongin-si (KR); PARK, Youngseo, 17113 Yongin-si (KR); AHN, Hongkyun, 17113 Yongin-si (KR); LEE, Jeongho, 17113 Yongin-si (KR)
(74) Representative: Marks & Clerk LLP

(57) **Abstract**

Provided are a display panel and a display apparatus including the same. A display panel includes a substrate including a first display area and a second display area, the second display area including a transmission area, first display elements located in the first display area and second display areas located in the second display area, the first display elements and the second display elements including a counter electrode integrally provided over the first display area and the second display area and including at least one transmission hole in an area corresponding to the transmission area, and a blocking layer at least partially overlapping an edge of the at least one transmission hole.

## Description

### BACKGROUND

### 1. Field

One or more embodiments relate to a display panel and a display apparatus including the same.

### 2. Description of the Related Art

Recently, display panels have been used for various purposes. Also, as thicknesses and weights of display panels have been decreased, the range of applications of display panels has increased.

As the area occupied by a display area in a display panel has been increased, various functions linked to or associated with the display panel have been added thereto. In order to increase a size and add various functions, research on a display panel having an area for adding various functions inside a display area continues.

### SUMMARY

A component such as a camera or a sensor may be located in a display area to add various functions to a display apparatus. In order to secure a wider display area and arrange a component therein, the component may overlap the display area. As a method of arranging a component in the display area, a display panel may include a transmission area through which light or sound may be transmitted. One or more embodiments include a display panel having the above structure and a display apparatus including the display panel.

Additional aspects will be set forth in part in the description which follows and, in part, will be apparent from the description, or may be learned by practice of the presented embodiments.

According to one or more embodiments, a display panel comprises or includes a substrate comprising or including a first display area and a second display area including a transmission area, first display elements located in the first display area and second display elements located in the second display area, the first display elements and the second display elements including a counter electrode integrally provided over the first display area and the second display area and including at least one transmission hole located in an area corresponding to the transmission area, and a blocking layer at least partially overlapping an edge of the at least one transmission hole.

The display panel may further comprise a pixel circuit layer located on the substrate, including first pixel circuits respectively connected to the first display elements and second pixel circuits respectively connected to the second display elements, and a bottom metal layer located between the substrate and the pixel circuit layer and overlapping at least one thin-film transistor included in the second pixel circuits, wherein the blocking layer and the bottom metal layer are formed of a same material and are located on a same layer.

The blocking layer may have a closed shape overlapping the entire edge of the at least one transmission hole and may include an opening through which a central portion of the at least one transmission hole is exposed.

The display panel may further include a pixel circuit layer located on the substrate and including first pixel circuits connected to the first display elements and second pixel circuits connected to the second display elements, wherein the blocking layer is a part of a wiring included in the pixel circuit layer.

A portion of the wiring constituting a blocking layer may have a width greater than that of another portion of the wiring.

The blocking layer may be a part of a data line configured to supply a data signal to one of the second pixel circuits.

The display panel may further include a thin-film encapsulation layer covering the first display elements and the second display elements, and an input sensing layer located on the thin-film encapsulation layer, wherein the blocking layer and a metal layer included in the input sensing layer are formed of a same material and are located on a same layer.

According to one or more embodiments, a display panel comprises or includes a substrate comprising or including a first display area in which first display elements are located and a second display area in which second display elements and a transmission area are located, a pixel circuit layer located on the substrate and including first pixel circuits located in the first display area and connected to the first display elements and second pixel circuits located in the second display area and connected to the second display elements, a bottom metal layer located between the substrate and the pixel circuit layer and at least partially overlapping the pixel circuit layer, a thin-film encapsulation layer covering the first display elements and the second display elements, and an input sensing layer located on the thin-film encapsulation layer, wherein the first display elements and the second display elements include a counter electrode, the counter electrode including at least one transmission hole located in an area corresponding to the transmission area, wherein at least one of a first metal layer located on a same layer as the bottom metal layer, a second metal layer included in the pixel circuit layer, and a third metal layer included in the input sensing layer at least partially overlaps an edge of the at least one transmission hole in a plan view.

The first metal layer may be provided in a closed shape overlapping the entire edge of the at least one transmission hole and including an opening through which a central portion of the at least one transmission hole is exposed.

The second metal layer may be located on a same layer as one electrode of a thin-film transistor included in the second pixel circuits.

The input sensing layer may have a structure in which a first touch conductive layer, a first touch insulating layer, a second touch conductive layer, and a second touch insulating layer are sequentially stacked, wherein the third metal layer is located on a same layer as the first touch conductive layer or the second touch conductive layer.

At least two of the first metal layer, the second metal layer, and the third metal layer may at least partially overlap the edge of the at least one transmission hole in a plan view.

A pixel-defining film defining emission areas of the first display elements and the second display elements may include an opening located in an area corresponding to the transmission area.

The at least one transmission hole may be provided in a triangular shape with rounded corners in a plan view.

The transmission area may include a first transmission area corresponding to a body portion of the counter electrode and a second transmission area corresponding to the at least one transmission hole of the counter electrode, wherein a light transmittance of the second transmission area is higher than a light transmittance of the first transmission area.

According to one or more embodiments, a display apparatus comprises or includes a display panel comprising or including a first display area and a second display area, the second display area including a transmission area, and a component located on a bottom surface of the display panel and overlapping the second display area, wherein the display panel comprises or includes a substrate, first display elements located in the first display area and second display elements located in the second display area, the first display elements and the second display elements including a counter electrode integrally provided over the first display area and the second display area and including at least one transmission hole located in an area corresponding to the transmission area, and a blocking layer at least partially overlapping an edge of the at least one transmission hole.

The display apparatus may further include a pixel circuit layer located on the substrate and including first pixel circuits respectively connected to the first display elements and second pixel circuits respectively connected to the second display elements, and a bottom metal layer located between the substrate and the pixel circuit layer and overlapping at least one thin-film transistor included in the second pixel circuits, wherein the blocking layer and the bottom metal layer are formed of a same material and are located on a same layer.

The display apparatus may further include a pixel circuit layer located on the substrate and including first pixel circuits connected to the first display elements and second pixel circuits connected to the second display elements, wherein the blocking layer is provided as a part of a wiring included in the pixel circuit layer.

The display apparatus may further include a thin-film encapsulation layer covering the first display elements and the second display elements, and an input sensing layer located on the thin-film encapsulation layer, wherein the blocking layer and a metal layer included in the input sensing layer are formed of a same material and are located on a same layer.

The blocking layer may be provided in a closed shape overlapping the entire edge of the at least one transmission hole and including an opening through which a central portion of the at least one transmission hole is exposed.

At least some of the above and other features of the invention are set out in the claims.

### BRIEF DESCRIPTION OF THE DRAWINGS

The above and other aspects, features, and advantages of certain embodiments will be more apparent from the following description taken in conjunction with the accompanying drawings, in which:
FIG. 1 is a perspective view illustrating a display apparatus according to an embodiment;
FIG. 2 is a plan view schematically illustrating a display apparatus according to an embodiment;
FIG. 3 is a cross-sectional view illustrating a part of a display apparatus according to an embodiment;
FIG. 4 is an equivalent circuit diagram schematically illustrating a pixel circuit electrically connected to a light-emitting diode of a display panel according to an embodiment;
FIG. 5 is a plan view illustrating a pixel arrangement in a part of a first display area of a display panel according to embodiments;
FIG. 6 is a plan view illustrating a pixel arrangement in a part of a second display area of a display panel according to embodiments;
FIG. 7 is a plan view schematically illustrating a shape of a counter electrode located in a second display area;
FIG. 8 is a plan view illustrating a part of a configuration of a display panel according to an embodiment;
FIG. 9 is a plan view illustrating a part of a configuration of a display panel according to an embodiment;
FIG. 10 is a plan view illustrating a part of a configuration of a display panel according to an embodiment;
FIG. 11 is a schematic cross-sectional view illustrating a display panel according to an embodiment;
FIG. 12 is a schematic cross-sectional view illustrating a display panel according to an embodiment;
FIG. 13 is a schematic cross-sectional view illustrating a display panel according to an embodiment;
FIG. 14 is a schematic cross-sectional view illustrating a display panel according to an embodiment; and
FIG. 15 is a schematic cross-sectional view illustrating a display panel according to an embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof

As the disclosure allows for various changes and numerous embodiments, certain embodiments will be illustrated in the drawings and described in the detailed description. Effects and features of the disclosure, and methods for achieving them will be clarified with reference to embodiments described below in detail with reference to the drawings. However, the disclosure is not limited to the following embodiments and may be embodied in various forms.

Hereinafter, embodiments will be described in detail with reference to the accompanying drawings, wherein the same or corresponding elements are denoted by the same reference numerals throughout and a repeated description thereof is omitted.

Although the terms "first," "second," etc. may be used to describe various elements, these elements should not be limited by these terms. These terms are only used to distinguish one element from another.

As used herein, the singular forms "a," "an," and "the" are intended to include the plural forms as well, unless the context clearly indicates otherwise.

It will be understood that the terms "comprising", "including," and "having," are intended to indicate the existence of the features or elements described in the specification, and are not intended to preclude the possibility that one or more other features or elements may exist or may be added.

It will be further understood that, when a layer, region, or component is referred to as being "on" another layer, region, or component, it may be directly on the other layer, region, or component, or may be indirectly on the other layer, region, or component with intervening layers, regions, or components therebetween.

In the following embodiments, the expression "at least one of A and B" is used to include a case in which only A is selected, a case in which only B is selected, and a case in which both A and B are selected.

Sizes of components in the drawings may be exaggerated or reduced for convenience of explanation. For example, because sizes and thicknesses of elements in the drawings are arbitrarily illustrated for convenience of explanation, the disclosure is not limited thereto.

When a certain embodiment may be implemented differently, a specific process order may be different from the described order. For example, two consecutively described processes may be performed substantially at the same time or may be performed in an order opposite to the described order.

It will be understood that when a layer, region, or component is referred to as being "connected," the layer, the region, or the component may be directly connected or may be indirectly connected with intervening layers, regions, or components disposed therebetween. For example, when layers, regions, or components are referred to as being "electrically connected," the layers, the regions, or the components may be directly electrically connected, or may be indirectly electrically connected with intervening layers, regions, or components disposed therebetween.

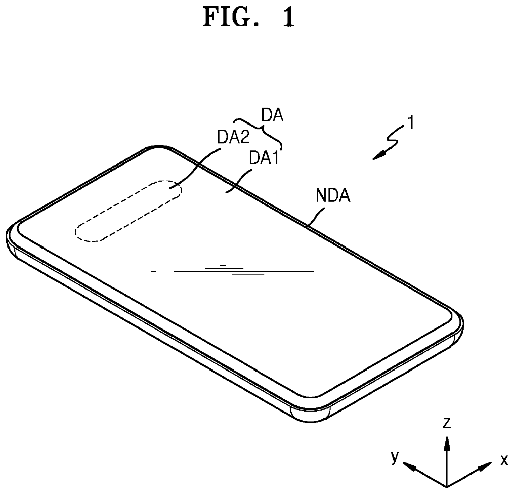

FIG. 1 is a perspective view illustrating a display apparatus according to an embodiment.

According to an embodiment, a display apparatus 1 for displaying a moving image or a still image may be used as a display screen not only for a portable display apparatus such as a mobile phone, a smartphone, a tablet personal computer (PC), a mobile communication terminal, an electronic organizer, an electronic book, a portable multimedia player (PMP), a navigation device, or an ultra-mobile PC (UMPC) but also for any of various products such as a television, a laptop computer, a monitor, a billboard, or an Internet of things (IoT) product. Also, the display apparatus 1 according to an embodiment may be used in a wearable device such as a smart watch, a watch phone, a glasses-type display, or a head-mounted display (HMD). Also, the display apparatus 1 according to an embodiment may be used as a center information display (CID) located on an instrument panel, a center fascia, or a dashboard of a vehicle, a room mirror display replacing a side-view mirror of a vehicle, or a display located on the back of a front seat for entertainment for an occupant in a back seat of a vehicle. For convenience of explanation, the display apparatus 1 is a smartphone in FIG. 1.

Referring to FIG. 1, the display apparatus 1 may include a display area DA and a non-display area NDA outside the display area DA. The display apparatus 1 may provide an image through an array of pixels that are two-dimensionally arranged in the display area DA.

The non-display area NDA where an image is not provided may entirely surround the display area DA. A driver or the like for applying an electrical signal or power to display elements located in the display area DA may be located in the non-display area NDA. A pad to which an electronic device or a printed circuit board may be electrically connected may be located in the non-display area NDA.

The display area DA may include a first display area DA1 and a second display area DA2. The second display area DA2 where a component for adding various functions to the display apparatus 1 is located may correspond to a component area.

Although the second display area DA2 is entirely surrounded by the first display area DA1 in FIG. 1, the disclosure is not limited thereto.

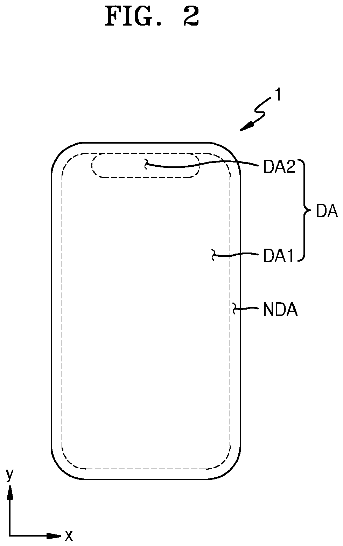

FIG. 2 is a plan view schematically illustrating a display apparatus according to an embodiment. As shown in FIG. 2, the second display area DA2 may be partially surrounded by the first display area DA1.

Although the second display area DA2 is located at an upper end of the display area DA in FIGS. 1 and 2, the disclosure is not limited thereto. Various modifications may be made. For example, the second display area DA2 may be located at a central portion or a lower end of the display area DA.

Although the second display area DA2 is provided in a long rectangular shape, the second display area DA2 may be provided in any of various shapes such as a circular shape, an elliptical shape, or a polygonal shape.

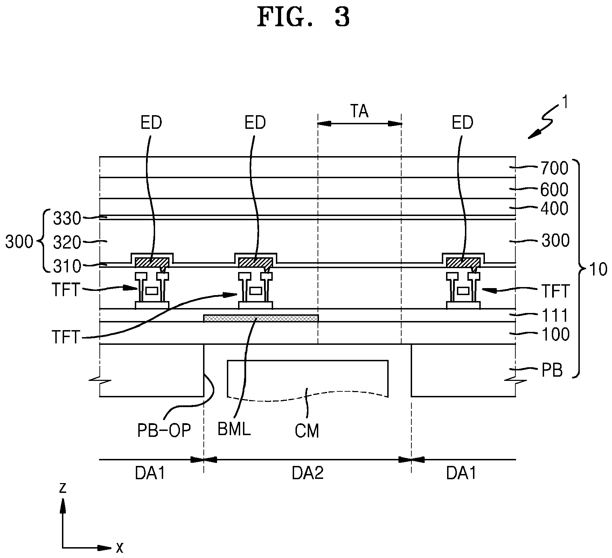

FIG. 3 is a cross-sectional view illustrating a part of a display apparatus according to an embodiment.

Referring to FIG. 3, the display apparatus 1 may include a display panel 10, and a component CM located on a bottom surface of the display panel 10 to overlap the display panel 10. The component CM may be located to correspond to the second display area DA2.

The display panel 10 may include a substrate 100, a thin-film transistor TFT located on the substrate 100, a display element (e.g., a light-emitting diode ED) electrically connected to the thin-film transistor TFT, a thin-film encapsulation layer 300 covering the display element, an input sensing layer 400, an optical functional layer 600, and a window 700.

The substrate 100 may include glass or a polymer resin. The substrate 100 including a polymer resin may be flexible, foldable, rollable, or bendable. The substrate 100 may have a multi-layer structure including a layer including the polymer resin and an inorganic layer (not shown).

A lower protective film PB may be located on a bottom surface of the substrate 100. The lower protective film PB may be attached to the bottom surface of the substrate 100. An adhesive layer may be located between the lower protective film PB and the substrate 100. Alternatively, the lower protective film PB may be formed directly on the bottom surface of the substrate 100, and, in this case, the adhesive layer may not be located between the lower protective film PB and the substrate 100.

The lower protective film PB may support and protect the substrate 100. The lower protective film PB may include an opening PB-OP corresponding to the second display area DA2. The lower protective film PB may include an organic insulating material such as polyethylene terephthalate (PET) or polyimide (PI).

The thin-film transistor TFT and the light-emitting diode ED that is a display element electrically connected to the thin-film transistor TFT may be located on a top surface of the substrate 100.

The light-emitting diode ED may be an organic light-emitting diode including an organic material. The organic light-emitting diode may emit red light, green light, or blue light. The light-emitting diode ED may be an inorganic light-emitting diode including an inorganic material. The inorganic light-emitting diode may include a PN junction diode including inorganic semiconductor-based materials. When a voltage is applied to a PN junction diode in a forward direction, holes and electrons may be injected, and energy generated by recombination of the holes and the electrons may be converted into light energy to emit light of a certain color. The inorganic light-emitting diode may have a width of several to hundreds of micrometers or several to hundreds of nanometers. In some embodiments, the light-emitting diode ED may include a quantum-dot light-emitting diode. An emission layer of the light-emitting diode ED may include an organic material, may include an inorganic material, may include quantum dots, may include an organic material and quantum dots, or may include an inorganic material and quantum dots.

The light-emitting diode ED may be electrically connected to the thin-film transistor TFT located under the light-emitting diode ED. In this regard, in FIG. 3, a buffer layer 111 is located on the substrate 100, and the thin-film transistor TFT is located on the buffer layer 111. The thin-film transistor TFT and the light-emitting diode ED electrically connected to the thin-film transistor TFT may be located in each of the first display area DA1 and the second display area DA2.

A transmission area TA may be located in the second display area DA2. The transmission area TA is an area through which light emitted from the component CM and/or light traveling to the component CM may be transmitted. In the display panel, a transmittance of the transmission area TA may be about 30% or more, about 40% or more, about 50% or more, about 60% or more, about 70% or more, about 75% or more, about 80% or more, about 85% or more, or about 90% or more.

The component CM may include a sensor such as a proximity sensor, an illuminance sensor, an iris sensor, or a facial recognition sensor, and a camera (or an image sensor). The component CM may use light. For example, the component CM may emit and/or receive light in infrared, ultraviolet, and/or visible bands. The proximity sensor using infrared rays may detect an object located close to a top surface of the display apparatus 1, and the illuminance sensor may detect a brightness of light incident on the top surface of the display apparatus 1. Also, the iris sensor may capture an image of the iris of a person located over the top surface of the display apparatus 1, and the camera may receive light from the object located over the top surface of the display apparatus 1.

In order to prevent a function of the thin-film transistor TFT located in the second display area DA2 from being degraded by light passing through the transmission area TA, a bottom metal layer BML may be located between the substrate 100 and the buffer layer 111. The bottom metal layer BML may be located in the second display area DA2 but may not be located in the transmission area TA. The bottom metal layer BML may overlap only some of a plurality of thin-film transistors TFT. The bottom metal layer BML may also be located in the first display area DA1.

The thin-film encapsulation layer 300 may cover the light-emitting diodes ED. The thin-film encapsulation layer 300 may include at least one inorganic encapsulation layer and at least one organic encapsulation layer. In an embodiment, the thin-film encapsulation layer 300 may include first and second inorganic encapsulation layers 310 and 330, and an organic encapsulation layer 320 disposed between the first and second inorganic encapsulation layers 310 and 330.

The input sensing layer 400 may be located on the thin-film encapsulation layer 300. The input sensing layer 400 may obtain coordinate information in response to an external input, for example, a touch event of an object such as a finger or a stylus pen. The input sensing layer 400 may include a touch electrode and trace lines connected to the touch electrode. The input sensing layer 400 may detect an external input by using a mutual capacitance method or a self-capacitance method.

The optical functional layer 600 may include an anti-reflection layer. The anti-reflection layer may reduce a reflectance of light (external light) incident on the display apparatus 1. In some embodiments, the optical functional layer 600 may be a polarizing film. In some embodiments, the optical functional layer 600 may be provided as a filter plate including a black matrix and color filters.

The window 700 is located on the optical functional layer 600. The window 700 may be coupled to the optical functional layer 600 through an adhesive layer such as an optically clear adhesive. The window 700 may include a glass material or a plastic material. The glass material may include ultra-thin glass. Examples of the plastic material may include polyethersulfone, polyacrylate, polyether imide, polyethylene naphthalate, polyethylene terephthalate, polyphenylene sulfide, polyarylate, polyimide, polycarbonate, and cellulose acetate propionate.

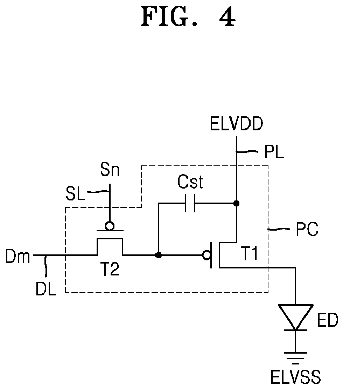

FIG. 4 is an equivalent circuit diagram schematically illustrating a pixel circuit electrically connected to a light-emitting diode of a display panel according to an embodiment.

Referring to FIG. 4, a pixel circuit PC may include a driving thin-film transistor T1, a switching thin-film transistor T2, and a storage capacitor Cst.

The switching thin-film transistor T2 may be connected to a scan line SL and a data line DL, and may transmit a data voltage (or a data signal Dm) input from the data line DL to the driving thin-film transistor T1 in response to a switching voltage (or a swing signal Sn) input from the scan line SL. The storage capacitor Cst may be connected between the switching thin-film transistor T2 and a driving voltage line PL, and may store a voltage corresponding to a difference between a data voltage received from the switching thin-film transistor T2 and a first power supply voltage ELVDD supplied to the driving voltage line PL.

The driving thin-film transistor T1 may be connected between the driving voltage line PL and the light-emitting diode ED, and may control driving current flowing from the driving voltage line PL to the light-emitting diode ED in response to a value of the voltage stored in the storage capacitor Cst. The light-emitting diode ED may emit light having a certain luminance according to the driving current. A counter electrode (e.g., a cathode) of the light-emitting diode ED may receive a second power supply voltage ELVSS.

Although the pixel circuit PC includes two thin-film transistors and one storage capacitor in FIG. 4, the disclosure is not limited thereto. The number of thin-film transistors and the number of storage capacitors may be changed in various ways according to a design of the pixel circuit PC. For example, the pixel circuit PC may include three, four, five, or more thin-film transistors. Also, the pixel circuit PC may include a plurality of capacitors.

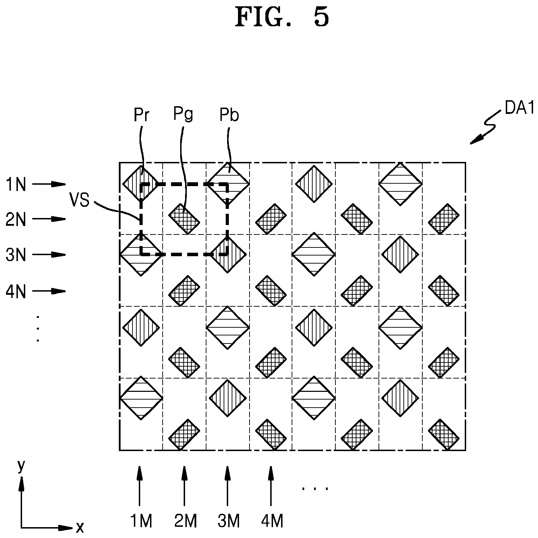

FIG. 5 is a plan view illustrating a pixel arrangement in a part of a first display area of a display panel according to embodiments. In the specification, a pixel may refer to a sub-pixel.

Referring to FIG. 5, pixels may be located in the first display area DA1, and the pixels may include first to third pixels emitting light of different colors. For convenience of explanation, the following will be described assuming that the first pixel is a red pixel Pr, the second pixel is a green pixel Pg, and the third pixel is a blue pixel Pb.

The red pixel Pr, the green pixel Pg, and the blue pixel Pb may be arranged in the first display area DA1 according to a certain rule. In some embodiments, the red pixel Pr, the green pixel Pg, and the blue pixel Pb may be arranged in a diamond pixel^{™} structure or a diamond pentile^{™} structure as shown in FIG. 1.

For example, a plurality of red pixels Pr and a plurality of blue pixels Pb are alternately arranged in a first row 1N, a plurality of green pixels Pg are arranged at certain intervals in a second row 2N disposed adjacent to the first row 1N, a plurality of blue pixels Pb and a plurality of red pixels Pr are alternately arranged in a third row 3N disposed adjacent to the second row 2N, and a plurality of green pixels Pg are arranged at certain intervals in a fourth row 4N disposed adjacent to the third row 3N, and this pixel arrangement is repeated up to an N^{th} row. In this case, the size (or width) of the blue pixel Pb and the red pixel Pr may be greater than the size (or width) of the green pixel Pg.

The plurality of red pixels Pr and blue pixels Pb located in the first row 1N and the plurality of green pixels Pg located in the second row 2N are alternately arranged. Accordingly, a plurality of red pixels Pr and a plurality of blue pixels Pb are alternately arranged in a first column 1M, a plurality of green pixels Pg are arranged at certain intervals in a second column 2M disposed adjacent to the first column 1M, a plurality of blue pixels Pb and a plurality of red pixels Pr are alternately arranged in a third column 3M disposed adjacent to the second column 2M, and a plurality of green pixels Pg are arranged at certain intervals in a fourth column 4M disposed adjacent to the third column 3M, and this pixel arrangement is repeated up to an M^{th} column.

In other words, from among vertices of a virtual quadrangular shape VS having a center point of the green pixel Pg as a center point of the quadrangular shape VS, the red pixels Pr may be located at first and third vertices that face each other, and the blue pixels Pb may be located at second and fourth vertices that are the remaining vertices. In this case, the virtual quadrangular shape VS may be modified to any of various shapes such as a rectangular shape, a diamond shape, or a square shape.

This pixel arrangement structure may be referred to as a diamond pixel^{™} structure or a diamond pentile^{™} structure, and because a rendering driving method that represents a color by sharing adjacent pixels is applied, a display image having a high resolution may be displayed with a small number of pixels.

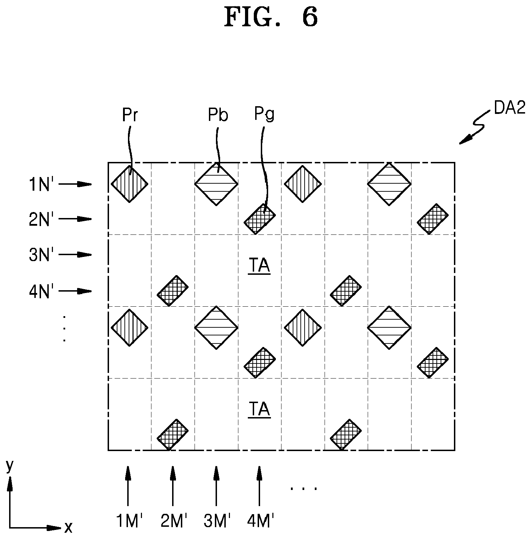

FIG. 6 is a plan view illustrating a pixel arrangement in a part of a second display area of a display panel according to embodiments.

Referring to FIG. 6, pixels may be located in the second display area DA2, and the pixels may include first to third pixels emitting light of different colors. The number of pixels located in the second display area DA2 per unit area may be less than the number of pixels located in the first display area DA1 per unit area. That is, a resolution of the second display area DA2 may be lower than a resolution of the first display area DA1. In some embodiments, a resolution of the second display area DA2 may be 1/2 of a resolution of the first display area DA1.

The pixels located in the second display area DA2 may be based on the same pixel arrangement structure as the first display area DA1, but may have a structure in which some pixels are not located. In this case, an area where pixels are not located may be the transmission area TA.

For example, a plurality of red pixels Pr and a plurality of blue pixels Pb may be alternately arranged in a first row 1N', and a plurality of green pixels Pg may be arranged at certain intervals in a second row 2N' disposed adjacent to the first row 1N'. In this case, the number of green pixels Pg located in the second row 2N' may be 1/2 of the number of green pixels Pg located in the first display area DA1, and an interval between the green pixels Pg located in the second display area DA2 in an x-direction may be twice an interval between the green pixels Pg located in the first display area DA1 in the x-direction.

Pixels may not be located in a third row 3N' disposed adjacent to the second row 2N'. That is, the entire third row 3N' may become the transmission area TA. A plurality of green pixels Pg may be arranged at certain intervals in a fourth row 4N' disposed adjacent to the third row 3N'. In this case, the number of green pixels Pg arranged in the fourth row 4N' may be 1/2 of the number of green pixels Pg located in the first display area DA1, and an interval between the green pixels Pg located in the second display area DA2 in the x-direction may be twice an interval between the green pixels Pg located in the first display area DA1 in the x-direction. This pixel arrangement is repeated to an N'^{th} row.

The plurality of red pixels Pr and blue pixels Pb located in the first row 1N' and the plurality of green pixels Pg located in the second row 2N' are alternately arranged in the y-direction.

The red pixels Pg are arranged at certain intervals in a first column 1M', and the green pixels Pg are arranged at certain intervals in a second column 2M'. The blue pixels Pb are arranged at certain intervals in a third column 3M', and the green pixels Pg are arranged at certain intervals in a fourth column 4M'. The green pixel Pg arranged in the second column 2M' and the green pixel Pg arranged in the fourth column 4M' may be alternately arranged in the y-direction.

The red pixel Pr, the green pixel Pg, and the blue pixel Pb of FIGS. 5 and 6 may respectively emit red light, green light, and blue light by using light-emitting diodes located in the corresponding pixels. Accordingly, an arrangement of pixels may correspond to an arrangement of emission areas of light-emitting diodes that are display elements. For example, a position of the red pixel Pr of FIGS. 5 and 6 may indicate a position of an emission area of a light-emitting diode that emits red light. Likewise, a position of the green pixel Pg may indicate a position of an emission area of a light-emitting diode that emits green light, and a position of the blue pixel Pb may indicate a position of an emission area of a light-emitting diode that emits blue light.

Although each of the red pixel Pr, the green pixel Pg, and the blue pixel Pb is provided in a quadrangular shape in FIGS. 5 and 6, each of the red pixel Pr, the green pixel Pg, and the blue pixel Pb may be provided in any of various shapes such as a circular shape, an elliptical shape, a polygonal shape such as a hexagonal shape, or a polygonal shape with rounded corners.

A pixel arrangement structure in the first display area DA1 and/or the second display area DA2 may be changed in various ways. For example, a pixel arrangement structure may be any of various structures such as a stripe structure, a mosaic arrangement structure, a delta arrangement structure, or a modification thereof.

Also, arrangements and/or sizes of the pixels located in the first display area DA1 and the pixels located in the second display area DA2 may be the same or different from each other.

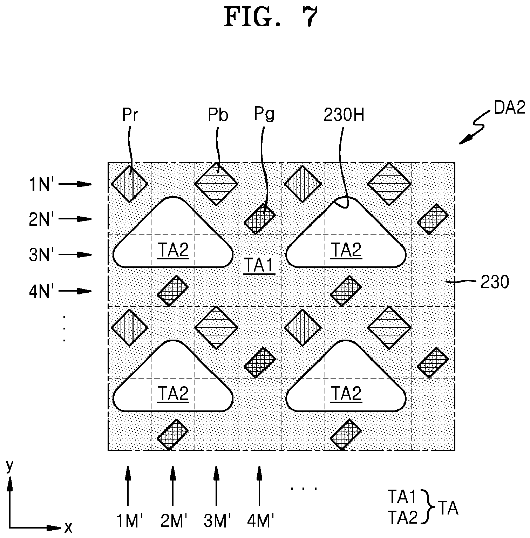

FIG. 7 is a plan view schematically illustrating a shape of a counter electrode 230 located in the second display area DA2. In the specification, a counter electrode refers to one electrode of a light-emitting diode that is a display element.

Referring to FIG. 7, the counter electrode 230 may be integrally provided over a plurality of pixels. That is, the counter electrode 230 may be integrally provided with respect to a plurality of light-emitting diodes. In the second display area DA2, the counter electrode 230 may include at least one transmission hole 230H corresponding to the transmission area TA where the pixels Pr, Pg, and Pb, that is, emission areas of the light-emitting didoes, are not located.

The counter electrode 230 may be formed of a light-transmitting material. Accordingly, even when the counter electrode 230 does not include the transmission hole 230H, a certain light transmittance may be ensured. Accordingly, the transmission area TA where a body portion of the counter electrode 230 is located may be referred to as a first transmission area TA1. Because the counter electrode 230 includes the transmission hole 230H, a second transmission area TA2 in which the counter electrode 230 is not disposed may have a higher light transmittance than the first transmission area TA1 in which the counter electrode 230 is disposed. Accordingly, a total light transmittance of the transmission area TA may increase.

The transmission hole 230H of the counter electrode 230 may be provided in a closed shape in a plan view. Although the transmission hole 230H has a triangular shape with rounded corners in FIG. 7, the disclosure is not limited thereto. The transmission hole 230H may have any of various planar shapes such as a circular shape, an elliptical shape, or a polygonal shape. A plurality of transmission holes 230H may be formed, and shapes, sizes, and arrangements of the plurality of transmission holes 230H may be changed in various ways. For example, the transmission holes 230H having different shapes and/or sizes may be provided, and the transmission holes 230H may be arranged regularly or irregularly.

Because the counter electrode 230 includes the transmission hole 230H, a light transmittance of the second display area DA2 may further increase. However, diffraction may occur around an edge of the transmission hole 230H due to a phase difference of light. Also, a misalignment can occur when forming the transmission hole 230H, or a position of the transmission hole 230H may shift from a designed position. Undesired diffraction may occur due to the misalignment of the transmission hole 230H. In particular, the undesired diffraction may be caused by a shift of the edge of the transmission hole 230H.

In embodiments, in order to minimize this phenomenon, a blocking layer overlapping the edge of the transmission hole 230H of the counter electrode 230 is introduced.

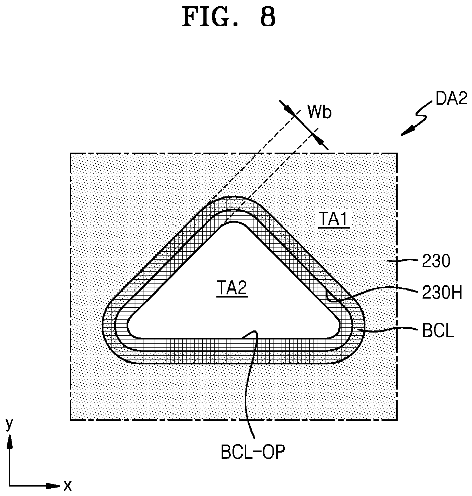

FIGS. 8 to 10 are plan views illustrating a part of a configuration of a display panel according to an embodiment. In detail, FIGS. 8 to 10 schematically illustrate the transmission hole 230H of the counter electrode 230 located in the second display area DA2 and a blocking layer BCL overlapping an edge of the transmission hole 230H in a plan view.

Referring to FIG. 8, in a display panel according to the present embodiment, the transmission hole 230H through which a lower structure of the counter electrode 230 may be exposed by removing a portion of the counter electrode 230 located in the second display area DA2. The transmission hole 230H may be formed in an area corresponding to the second transmission area TA2 of the second display area DA2.

The blocking layer BCL may at least partially overlap the edge (or an outline) of the transmission hole 230H. The blocking layer BCL may have a certain width Wb in a plan view, and may be located along the edge of the transmission hole 230H, that is, a boundary between a body portion of the counter electrode 230 and the transmission hole 230H. The edge of the transmission hole 230H may overlap the blocking layer BCL in a plan view.

The width Wb of the blocking layer BCL may be set in consideration of a misalignment margin in a process and a light transmittance of the transmission area. In some embodiments, the width Wb of the blocking layer BCL may be set twice the misalignment margin in a process, for example, range from about 10 µm to about 20 µm. When the width Wb of the blocking layer BCL is less than 10 µm, the misalignment margin exceed the width Wb of the blocking layer BCL and, thus, the edge of the transmission hole 230H may not be overlapped with the blocking layer BCL in a plan view. When the width Wb of the blocking layer BCL is greater than 20 µm, the transmission area TA may be relatively narrow, thereby lowering a light transmittance.

In some embodiments, the blocking layer BCL may be provided in a closed shape overlapping the entire edge of the transmission hole 230H and including an opening BCL_OP overlapping a central portion of the transmission hole 230H. For example, the blocking layer BCL may have a donut shape or a ring shape. In this case, the opening BCL_OP of the blocking layer BCL may define the second transmission area TA2. The area of the opening BCL_OP of the blocking layer BCL may be less than the area of the transmission hole 230H. The blocking layer BCL may include an inner circumference defining the opening and an outer circumference overlapping the counter electrode 230. An area corresponding to a transmission area outside the outer circumference of the blocking layer BCL may correspond to the first transmission area TA1, and an area corresponding to the inside of the inner circumference of the blocking layer BCL may correspond to the second transmission area TA2.

In some embodiments, the blocking layer BCL may be provided as a metal layer forming the display panel. When the component CM (see FIG. 3) uses an infrared wavelength band, light absorption may be facilitated when the blocking layer BCL is formed of a metal. However, the disclosure is not limited thereto. The blocking layer BCL may include an organic insulating material or an inorganic insulating material including a light-absorbing material rather than a metal.

The blocking layer BCL may be located farther from the substrate 100 (see FIG. 3) than the counter electrode 230, or located closer to the substrate 100 (see FIG. 3) than the counter electrode 230. That is, the blocking layer BCL may be located over or under the counter electrode 230. Also, various modifications may be made. For example, the blocking layer BCL may be located over and under the counter electrode 230.

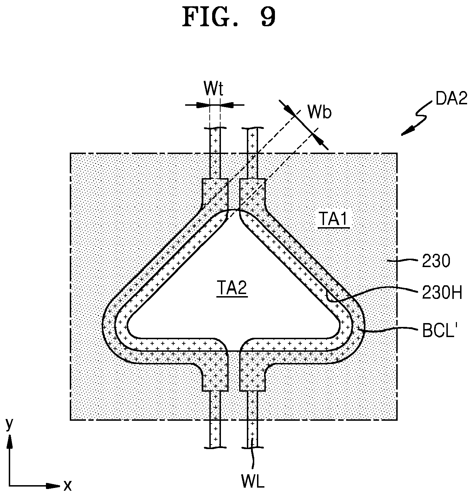

Referring to FIG. 9, a blocking layer BCL' of a display panel according to the present embodiment may be provided as a part of a wiring WL included in a pixel circuit layer of the display panel. The wiring WL may substantially extend in a second direction (y-direction), and may extend to overlap an edge of the transmission hole 230H at a portion overlapping the transmission hole 230H of the counter electrode 230. In this case, a portion of the wiring WL overlapping the edge of the transmission hole 230H may be the blocking layer BCL'.

The wiring WL may have a first width Wt and a portion corresponding to the blocking layer BCL' may have a second width Wb greater than the first width.

In some embodiments, the wiring WL may be a data line that applies a data signal to the pixel circuits. Alternatively, the wiring WL may be a driving voltage line that supplies a driving voltage to the pixel circuits.

Although the blocking layer BCL' is provided as a part of the wiring WL substantially extending in the second direction (y-direction) in FIG. 9, the disclosure is not limited thereto. Various modifications may be made. For example, the blocking layer BCL' may be provided as a part of a wiring extending in a first direction (x-direction).

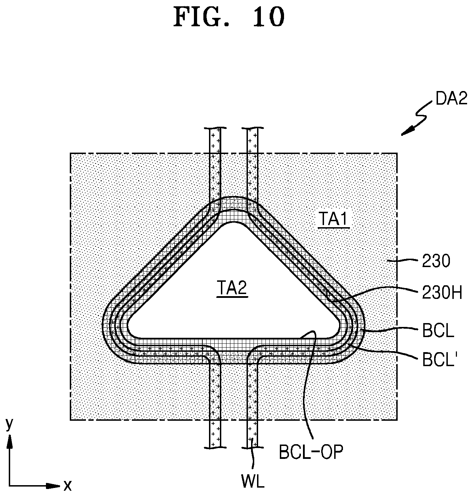

Referring to FIG. 10, the blocking layers BCL and BCL' may be provided as a plurality of layers located on different layers and overlapping each other.

In some embodiments, the first blocking layer BCL may be provided as a metal layer over and/or under the counter electrode 230, and may be provided in a closed shape including the opening BCL_OP at the center. The second blocking layer BCL' may be provided as a part of the wiring WL included in the display panel. The first blocking layer BCL and the second blocking layer BCL' may at least partially overlap the edge of the transmission hole 230H of the counter electrode 230. Also, the first blocking layer BCL and the second blocking layer BCL' may at least partially overlap each other. In this case, a width of the wiring WL may be constant even in a portion corresponding to the second blocking layer BCL'. However, as shown in FIG. 9, a portion of the wiring WL corresponding to the second blocking layer BCL' may have a greater width than other portions.

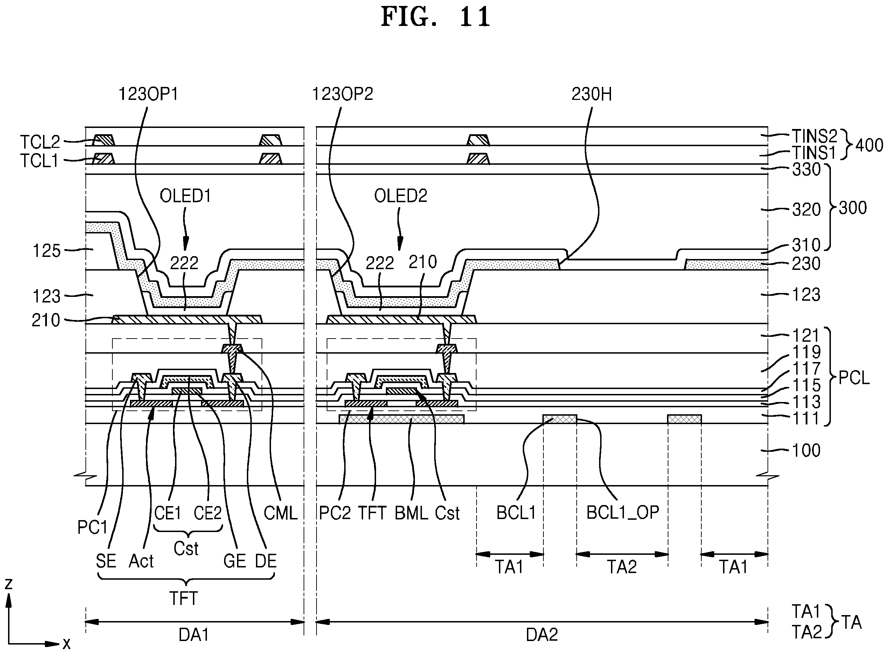

FIG. 11 is a schematic cross-sectional view illustrating a part of a first display area and a part of a second display area of a display panel according to an embodiment. In FIG. 11, a display element of the display panel is an organic light-emitting diode. An organic light-emitting diode may be located as a display element in each of the first and second display areas DA1 and DA2, and, for convenience of explanation, an organic light-emitting diode located in the first display area DA1 is referred to as a first organic light-emitting diode OLED1 and an organic light-emitting diode located in the second display area DA2 is referred to as a second organic light-emitting diode OLED2.

Referring to FIG. 11, a display panel according to an embodiment may include the substrate 100, the counter electrode 230 integrally provided over the first organic light-emitting diode OLED1 that is a first display element and the second organic light-emitting diode OLED2 that is a second display element and including the transmission hole 230H, and a first metal layer BCL1 which is a blocking layer at least partially overlapping an edge of the transmission hole 230H. Also, the display panel according to an embodiment includes a pixel circuit layer PCL located between the substrate 100 and the display elements. The pixel circuit layer PCL may include a first pixel circuit PC1 and a second pixel circuit PC2.

The substrate 100 may be formed of any of various materials such as a glass material, a metal material, or a polymer resin. The polymer resin may include polyethersulfone, polyacrylate, polyether imide, polyethylene naphthalate, polyethylene terephthalate, polyphenylene sulfide, polyarylate, polyimide, polycarbonate, and/or cellulose acetate propionate. The substrate 100 may have a structure in which a polymer resin and an inorganic insulating material are stacked.

The buffer layer 111 may be located on the substrate 100. The buffer layer 111 may reduce or prevent penetration of a foreign material, moisture, or external air from the bottom of the substrate 100. The gate insulating layer 112 may include an inorganic insulating material such as silicon oxide, silicon oxynitride, or silicon nitride, and may have a single or multi-layer structure including the above material.

The bottom metal layer BML may be located between the substrate 100 and the buffer layer 111, and may be located in the second display area DA2. The bottom metal layer BML may prevent light traveling toward the component CM (see FIG. 3) located in the second display area DA2 or light emitted from the component CM from affecting an electronic element such as a thin-film transistor TFT of the second pixel circuit PC2.

The bottom metal layer BML may include a conductive metal such as aluminum (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), and/or copper (Cu).

The first organic light-emitting diode OLED1 and the second organic light-emitting diode OLED2 may be electrically connected to the first pixel circuit PC1 and the second pixel circuit PC2, respectively, included in the pixel circuit layer PCL. The first organic light-emitting diode OLED1 may be electrically connected to the first pixel circuit PC1 between the substrate 100 and the first organic light-emitting diode OLED1, and the second organic light-emitting diode OLED2 may be electrically connected to the second pixel circuit PC2 between the substrate 100 and the second organic light-emitting diode OLED2.

Each of the first pixel circuit PC1 and the second pixel circuit PC2 may include a thin-film transistor TFT and a storage capacitor Cst. The thin-film transistor TFT may include a semiconductor layer Act, a gate electrode GE overlapping a channel region of the semiconductor layer Act, and a source electrode SE and a drain electrode DE respectively connected to a source region and a drain region of the semiconductor layer Act. A gate insulating layer 113 may be located between the semiconductor layer Act and the gate electrode GE, and a first interlayer insulating layer 115 and a second interlayer insulating layer 117 may be located between the gate electrode GE and the source electrode SE or between the gate electrode GE and the drain electrode DE.

The storage capacitor Cst may overlap the thin-film transistor TFT. The storage capacitor Cst may include a lower electrode CE1 and an upper electrode CE2 overlapping each other. In some embodiments, the gate electrode GE of the thin-film transistor TFT may constitute the lower electrode CE1 of the storage capacitor Cst. The first interlayer insulating layer 115 may be located between the lower electrode CE1 and the upper electrode CE2.

The semiconductor layer Act may include polysilicon. In some embodiments, the semiconductor layer Act may include amorphous silicon. In some embodiments, the semiconductor layer A1 may include an oxide semiconductor of at least one material selected from the group consisting of indium (In), gallium (Ga), stannum (Sn), zirconium (Zr), vanadium (V), hafnium (Hf), cadmium (Cd), germanium (Ge), chromium (Cr), titanium (Ti), and zinc (Zn). The semiconductor layer Act may include the channel region, and the source region and the drain region doped with impurities.

The gate insulating layer 113 may include an inorganic insulating material such as silicon oxide, silicon oxynitride, or silicon nitride, and may have a single or multi-layer structure including the above material.

The gate electrode GE or the lower electrode CE1 may include a low-resistance conductive material such as molybdenum (Mo), aluminum (Al), copper (Cu), and/or titanium (Ti), and may have a single or multi-layer structure including the above material.

The first interlayer insulating layer 115 may include an inorganic insulating material such as silicon oxide, silicon oxynitride, or silicon nitride, and may have a single or multi-layer structure including the above material.

The upper electrode CE2 may include aluminum (Al), platinum (Pt), palladium (Pd), silver (Ag), magnesium (Mg), gold (Au), nickel (Ni), neodymium (Nd), iridium (Ir), chromium (Cr), nickel (Ni), calcium (Ca), molybdenum (Mo), titanium (Ti), tungsten (W), and/or copper (Cu), and may have a single or multi-layer structure including the above material.

The second interlayer insulating layer 117 may include an inorganic insulating material such as silicon oxide, silicon oxynitride, or silicon nitride, and may have a single or multi-layer structure including the above material.

The source electrode SE and/or the drain electrode DE may include aluminum (Al), platinum (Pt), palladium (Pd), silver (Ag), magnesium (Mg), gold (Au), nickel (Ni), neodymium (Nd), iridium (Ir), chromium (Cr), nickel (Ni), calcium (Ca), molybdenum (Mo), titanium (Ti), tungsten (W), and/or copper (Cu), and may have a single or multi-layer structure including the above material. For example, the source electrode SE or the drain electrode DE may have a three-layer structure including a titanium layer, an aluminum layer, and a titanium layer.

A first organic insulating layer 119 may be located on the thin-film transistor TFT, and the thin-film transistor TFT may be electrically connected to a pixel electrode 210 of a corresponding organic light-emitting diode through a connection electrode layer CML located on the first organic insulating layer 119. The connection electrode layer CML may be connected to the thin-film transistor TFT through a contact hole formed through the first organic insulating layer 119, and the pixel electrode 210 may be connected to the connection electrode layer CML through a contact hole formed through a second organic insulating layer 121.

The first organic insulating layer 119 and/or the second organic insulating layer 121 may include an organic insulating material such as acryl, benzocyclobutene (BCB), polyimide, or hexamethyldisiloxane (HMDSO). In some embodiments, the connection electrode layer CML and the second organic insulating layer 121 may be omitted, and in this case, the pixel electrode 210 may be directly connected to the thin-film transistor TFT through a contact hole formed through the first organic insulating layer 119.

Each of the first organic light-emitting diode OLED1 and the second organic light-emitting diode OLED2 may include an overlapping structure of the pixel electrode 210, an emission layer 222, and the counter electrode 230. The overlapping structure may include a first functional layer (not shown) between the pixel electrode 210 and the emission layer 222 and/or a second functional layer (not shown) between the emission layer 222 and the counter electrode 230.

The pixel electrode 210 may be located on the second organic insulating layer 121. The pixel electrode 210 may include a reflective film including silver (Ag), magnesium (Mg), aluminum (Al), platinum (Pt), palladium (Pd), gold (Au), nickel (Ni), neodymium (Nd), iridium (Ir), chromium (Cr), or a compound thereof. The pixel electrode 210 may include the reflective film including the above material, and a transparent conductive film located over and/or under the reflective film. The transparent conductive film may include indium tin oxide (ITO), indium zinc oxide (IZO), zinc oxide (ZnO), indium oxide (In₂O₃), indium gallium oxide (IGO), or aluminum zinc oxide (AZO). In an embodiment, the pixel electrode 210 may have a three-layer structure including an ITO layer, an Ag layer, and an ITO layer.

A pixel-defining film 123 may cover an edge of the pixel electrode 210 and may include an opening overlapping the pixel electrode 210. In this regard, FIG. 11 illustrates an opening (hereinafter, referred to as a first opening 123OP1) overlapping the pixel electrode 210 of the first organic light-emitting diode OLED1 and an opening (hereinafter, referred to as a second opening 123OP2) overlapping the pixel electrode 210 of the second organic light-emitting diode OLED2. Although the second opening 123OP2 is larger than the first opening 123OP1 in FIG. 11, the disclosure is not limited thereto. The area of the second opening 123OP2 may be the same as that of the first opening 123OP1.

The first opening 123OP1 and the second opening 123OP2 of the pixel-defining film 123 may respectively define emission areas of the first and second organic light-emitting diodes OLED1 and OLED2. For example, a width of the first opening 123OP1 of the pixel-defining film 123 may correspond to a width of the emission area of the first organic light-emitting diode OLED1, and a width of the second opening 123OP2 of the pixel-defining film 123 may correspond to a width of the emission area of the second organic light-emitting diode OLED2.

A spacer 125 may be located on the pixel-defining film 123. The spacer 125 may protrude from a top surface of the pixel-defining film 123. The spacer 125 may be an element for preventing damage in a mask process for forming the emission layer 222, etc.

The spacer 125 may be formed of an organic insulating material such as polyimide, polyamide, acrylic resin, benzocyclobutene, hexamethyldisiloxane (HMDSO), or phenolic resin, by using spin coating or the like. The spacer 125 and the pixel-defining film 123 may be formed of the same material through the same process. In this case, thicknesses of the spacer 125 and the pixel-defining film 123 may be different from each other by using a full tone mask and a half-tone mask.

The emission layer 222 may be located to correspond to each of the first opening123OP1 and the second opening 123OP2 of the pixel-defining film 123, and may overlap the pixel electrode 210. The emission layer 222 may include a high molecular weight organic material or a low molecular weight organic material emitting light of a certain color. The first functional layer (not shown) and the second functional layer (not shown) may be formed under and over the emission layer 222.

The first functional layer may include a hole transport layer (HTL) and/or a hole injection layer (HIL). The second functional layer may include an electron transport layer (ETL) and/or an electron injection layer (EIL). The first functional layer and/or the second functional layer may be entirely formed on the substrate 100. In other words, the first functional layer and/or the second functional layer may cover the first display area DA1 and the second display area DA2.

The counter electrode 230 is located on the emission layer 222. The counter electrode 230 may include a conductive material having a low work function. For example, the counter electrode 230 may include a (semi-)transparent layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), or an alloy thereof. Alternatively, the counter electrode 230 may further include a layer formed of ITO, IZO, ZnO, or In₂O₃ on the (semi-)transparent layer including the above material. The counter electrode 230 may be integrally formed to correspond to the first and second organic light-emitting diodes OLED 1 and OLED2 located in the first display area DA1 and the second display area DA2.

The counter electrode 230 may include the transmission hole 230H corresponding to the transmission area TA. When the transmission hole 230H corresponds to the transmission area TA, it may mean that the transmission hole 230H overlaps the transmission area TA.

Due to the transmission hole 230H, a part of the counter electrode 230 may not exist in the transmission area TA, and thus, a light transmittance in the transmission area TA may significantly increase. The counter electrode 230 including the transmission hole 230H may be formed by using any of various methods. In an embodiment, the counter electrode 230 including the transmission hole 230H may be formed by forming a material for forming the counter electrode 230 on an entire surface of the substrate 100 and then removing a portion corresponding to the transmission area TA through laser lift-off. In another embodiment, the counter electrode 230 including the transmission hole 230H may be formed through a metal self-patterning (MSP) method. In another embodiment, the counter electrode 230 including the transmission hole 230H may be formed through a method of depositing the counter electrode 230 by using a fine metal mask (FMM).

The thin-film encapsulation layer 300 may cover the first and second organic light-emitting diodes OLED1 and OLED2. In an embodiment, the thin-film encapsulation layer 300 may include the first inorganic encapsulation layer 310, the second inorganic encapsulation layer 330, and the organic encapsulation layer 320 disposed between the first inorganic encapsulation layer 310 and the second inorganic encapsulation layer 330.

Each of the first and second inorganic encapsulation layers 310 and 330 may include at least one inorganic insulating material. The inorganic insulating material may include aluminum oxide, titanium oxide, tantalum oxide, hafnium oxide, silicon oxide, silicon nitride, and/or silicon oxynitride.

The organic encapsulation layer 320 may include a polymer-based material. Examples of the polymer-based material may include an acrylic resin, an epoxy resin, polyimide, and polyethylene. For example, the organic encapsulation layer 320 may include an acrylic resin such as polymethyl methacrylate or polyacrylic acid. The organic encapsulation layer 320 may be formed by curing a monomer or applying a polymer.

The input sensing layer 400 may be formed on the thin-film encapsulation layer 300. The input sensing layer 400 is a touchscreen layer and may obtain coordinate information according to an external input, for example, a touch event of an object such as a finger or a stylus pen.

The input sensing layer 400 may have a structure in which a first touch conductive layer TCL1, a first touch insulating layer TINS1, a second touch conductive layer TCL2, and a second touch insulating layer TINS2 are sequentially stacked. A touch buffer layer (not shown) formed of an insulating material may be further located under the first touch conductive layer TCL1.

In some embodiments, the second touch conductive layer TCL2 may function as a touch electrode for sensing contact, and the first touch conductive layer TCL1 may function as a connector for connecting the patterned second touch conductive layer TCL2 in one direction.

In some embodiments, both the first touch conductive layer TCL1 and the second touch conductive layer TCL2 may function as touch electrodes. For example, the first touch insulating layer TINS 1 may include a via hole through which a top surface of the first touch conductive layer TCL1 is exposed, and the first touch conductive layer TCL1 and the second touch conductive layer TCL2 may be connected to each other through the via hole. As the first touch conductive layer TCL1 and the second touch conductive layer TCL2 are used, the resistance of a touch electrode may be reduced and a response speed of the input sensing layer 400 may be improved

In some embodiments, the touch electrode may be formed in a mesh structure so that light emitted from the first organic light-emitting diode OLED1 and the second organic light-emitting diode OELD2 may pass through holes formed through the touch electrode. Accordingly, the first touch conductive layer TCL1 and the second touch conductive layer TCL2 may not overlap the emission areas of the organic light-emitting diodes OLED1 and OLED2.

Each of the first touch conductive layer TCL1 and the second touch conductive layer TCL2 may have a single or multi-layer structure formed of a metal. For example, the first touch conductive layer TCL1 and the second touch conductive layer TCL2 may have a single or multi-layer structure formed of a conductive material such as aluminum (Al), copper (Cu), molybdenum (Mo), and/or titanium (Ti). In some embodiments, the first touch conductive layer TCL1 may be formed of molybdenum (Mo), and the second touch conductive layer TCL2 may have a stacked structure including Ti/Al/Ti.

Each of the first touch insulating layer TINS 1 and the second touch insulating layer TINS2 may be formed of at least one inorganic insulating material or organic insulating material. The inorganic insulating material may include aluminum oxide, titanium oxide, tantalum oxide, hafnium oxide, silicon oxide, silicon nitride, and/or silicon oxynitride. The organic insulating material may be at least one of an acrylic resin, a methacrylic resin, polyisoprene, a vinyl resin, an epoxy resin, a urethane resin, a cellulose resin, and a perylene resin.

In the present embodiment, the first metal layer BCL1 at least partially overlaps an edge of the transmission hole 230H of the counter electrode 230. The first metal layer BCL1 may include an opening BCL1_OP disposed in an area corresponding to the transmission hole 230H. The second transmission area TA2 may be defined by the opening BCL_OP. In the transmission area TA, a portion outside the first metal layer BCL1 may be the first transmission area TA1.

The first metal layer BCL1 and the bottom metal layer BML may be formed of the same material and may be located on the same layer. The first metal layer BCL1 may be located between the substrate 100 and the buffer layer 111. The first metal layer BCL1 may have a single or multi-layer structure including aluminum (Al), platinum (Pt), palladium (Pd), silver (Ag), magnesium (Mg), gold (Au), nickel (Ni), neodymium (Nd), iridium (Ir), chromium (Cr), nickel (Ni), calcium (Ca), molybdenum (Mo), titanium (Ti), tungsten (W), and/or copper (Cu).

The first metal layer BCL1 may be provided in a closed shape having an opening at a central portion as shown in FIG. 8, or may be provided as a part of a wiring as shown in FIG. 9.

The misalignment when forming the first metal layer BCL1 may be less than that when forming the transmission hole 230H of the counter electrode 230. Because the first metal layer BCL1 covers the edge of the transmission hole 230H, a position of the second transmission area TA2 may be formed as designed. Accordingly, the generation of an undesired diffraction signal may be minimized.

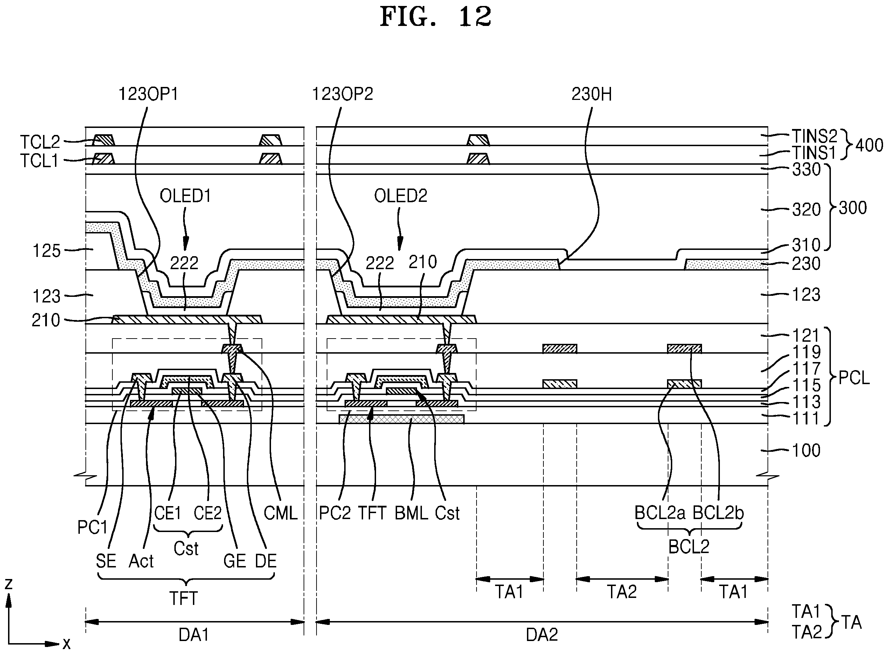

FIGS. 12 to 15 are cross-sectional views schematically illustrating a display panel according to embodiments. In FIGS. 12 to 15, the same members as those in FIG. 11 are denoted by the same reference numerals, and thus, a repeated description thereof will be omitted.

Referring to FIGS. 12 to 15, a display panel according to embodiments includes the substrate 100 including the first display area DA1 and the second display area DA2, the bottom metal layer BML, the pixel circuit layer PCL, display elements integrally including the counter electrode 230, the thin-film encapsulation layer 300, and the input sensing layer 400. The counter electrode 230 may include at least one transmission hole 230H corresponding to the second display area DA2.

Also, the display panel according to embodiments includes the first metal layer BCL1 located on the same layer as the bottom metal layer BML, a second metal layer BCL2 included in the pixel circuit layer PCL, and a third metal layer BCL3 included in the input sensing layer 400, and at least one of the first metal layer BCL1, the second metal layer BCL2, and the third metal layer BCL3 at least partially overlap an edge of the transmission hole 230H of the counter electrode 230.

Referring to FIG. 12, the display panel according to an embodiment may include the substrate 100, the counter electrode 230 integrally provided over the first organic light-emitting diode OLED1 that is a first display element and the second organic light-emitting diode OLED2 that is a second display element and including the transmission hole 230H, and the second metal layer BCL2 as a blocking layer at least partially overlapping the edge of the transmission hole 230H. The second metal layer BCL2 may be a metal layer which is disposed on the same layer and formed at the same time with a metal layer included in the pixel circuit layer PCL.

The second metal layer BCL2 may include a 2-1 metal layer BCL2a and/or a 2-2 metal layer BCL2b as metal layers included in the pixel circuit layer PCL. The second metal layer BCL2 may be provided in a closed shape having an opening at a central portion as shown in FIG. 8, or may be provided as a part of a wiring as shown in FIG. 9.

The 2-1 metal layer BCL2a and the source electrode SE and/or the drain electrode DE of the thin-film transistor TFT may be formed of the same material and may be located on the same layer. The 2-1 metal layer BCL2a may be located on the second interlayer insulating layer 117. The 2-2 metal layer BCL2b and the connection electrode layer CML may be formed of the same material and may be located on the same layer. The 2-2 metal layer BCL2b may be located on the first organic insulating layer 119.

Although the 2-1 metal layer BCL2a and the 2-2 metal layer BCL2b overlap each other in FIG. 12, the disclosure is not limited thereto. Only one of the 2-1 metal layer BCL2a and the 2-2 metal layer BCL2b may be located. Also, the second metal layer BCL2 may include a metal layer located on the same layer as the gate electrode GE1 and/or a metal layer located on the same layer as the upper electrode CE2 of the storage capacitor Cst.

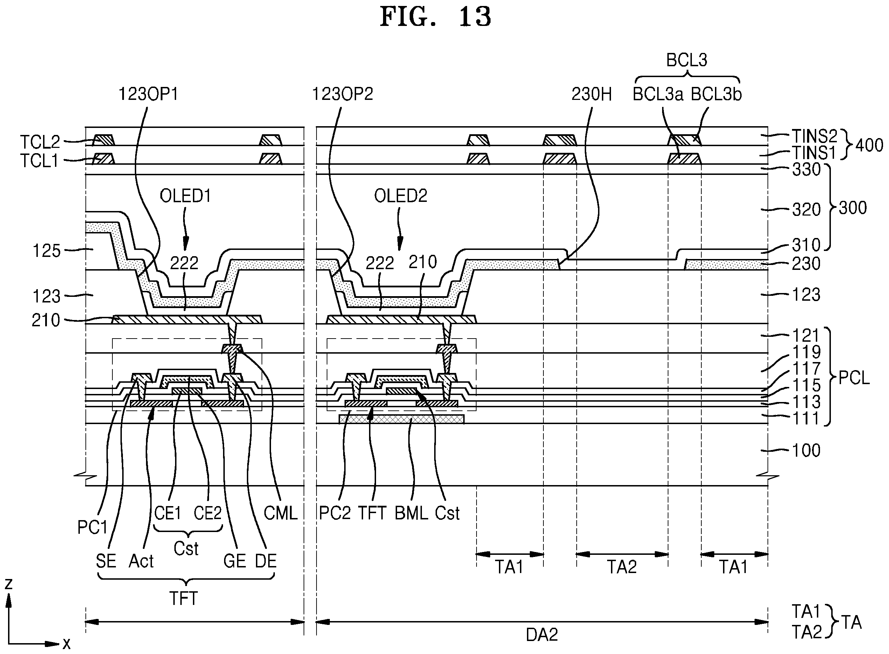

Referring to FIG. 13, a display panel according to an embodiment may include the substrate 100, the counter electrode 230 integrally provided over the first organic light-emitting diode OLED1 that is a first display element and the second organic light-emitting diode OLED2 that is a second display element and including the transmission hole 230H, and the third metal layer BCL3 as a blocking layer at least partially overlapping an edge of the transmission hole 230H.

The third metal layer BCL3 may include a 3-1 metal layer BCL3a and/or a 3-2 metal layer BCL3b which is disposed on the same layer and formed at the same time with the first touch conductive layer TCL1 and the second touch conductive layer TCL2 in the input sensing layer 400, respectively. The third metal layer BCL3 may be provided in a closed shape having an opening at a central portion as shown in FIG. 8, or may be provided as a part of a wiring as shown in FIG. 9.

The 3-1 metal layer BCL3a and the first touch conductive layer TCL1 may be formed of the same material and may be located on the same layer. The 3-2 metal layer BCL3b and the second touch conductive layer TCL2 may be formed of the same material and may be located on the same layer.

Although the 3-1 metal layer BCL3a and the 3-2 metal layer BCL3b overlap each other in FIG. 13, the disclosure is not limited thereto. Only one of the 3-1 metal layer BCL3a and the 3-2 metal layer BCL3b may be so located.

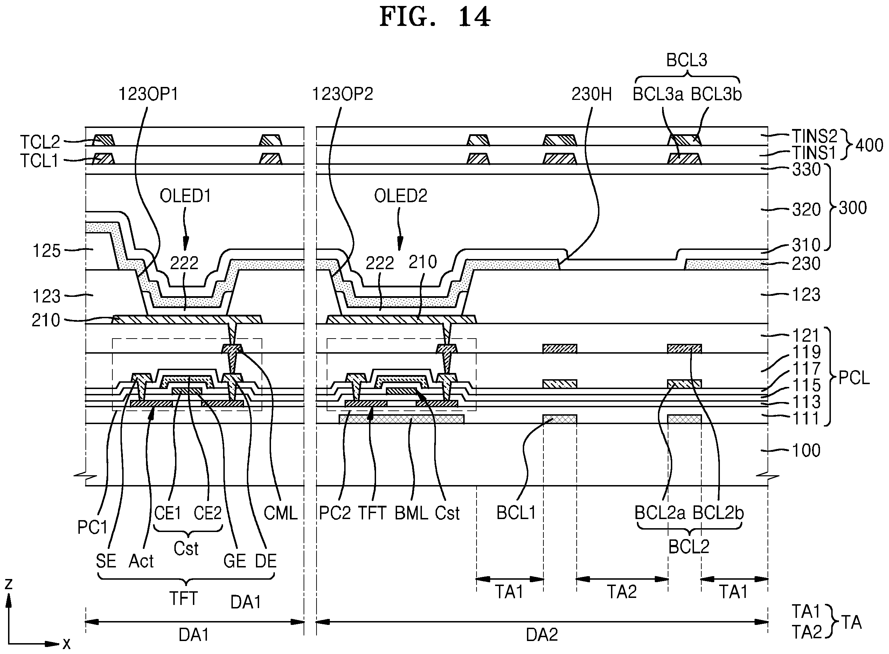

Referring to FIG. 14, at least two of the first metal layer BCL1 located on the same layer as the bottom metal layer, the second metal layer BCL2 included in the pixel circuit layer PCL, and the third metal layer BCL3 included in the input sensing layer 400 may at least partially overlap the edge of the transmission hole 230H of the counter electrode 230 in a plan view.

As shown in FIG. 14, all of the first metal layer BCL1, the second metal layer BCL2, and the third metal layer BCL3 may overlap the edge of the transmission hole 230H of the counter electrode 230. However, the disclosure is not limited thereto. Various modifications may be made. For example, only one of the first metal layer BCL1, the second metal layer BCL2 and the third metal layer BCL3 may overlap the edge of the transmission hole 230H as disclosed in FIGS. 11-13, or any two of the first metal layer BCL1, the second metal layer BCL2 and the third metal layer BCL3 may overlap the edge of the transmission hole 230H. For example, the first metal layer BCL1 and the second metal layer BCL2 may overlap the edge of the transmission hole 230H, the second metal layer BCL2 and the third metal layer BCL4 may overlap the edge of the transmission hole 230H, or the first metal layer BCL1 and the third metal layer BCL3 may overlap the edge of the transmission hole 230H. When the second metal layer BCL2 and/or the third metal layer BCL3 which includes more than one metal layer overlap(s) the edge of the transmission hole 230H, one or both of the metal layers included in the second metal layer BCL2 and/or the third metal layer BCL3 may overlap the edge of the transmission hole 230H.

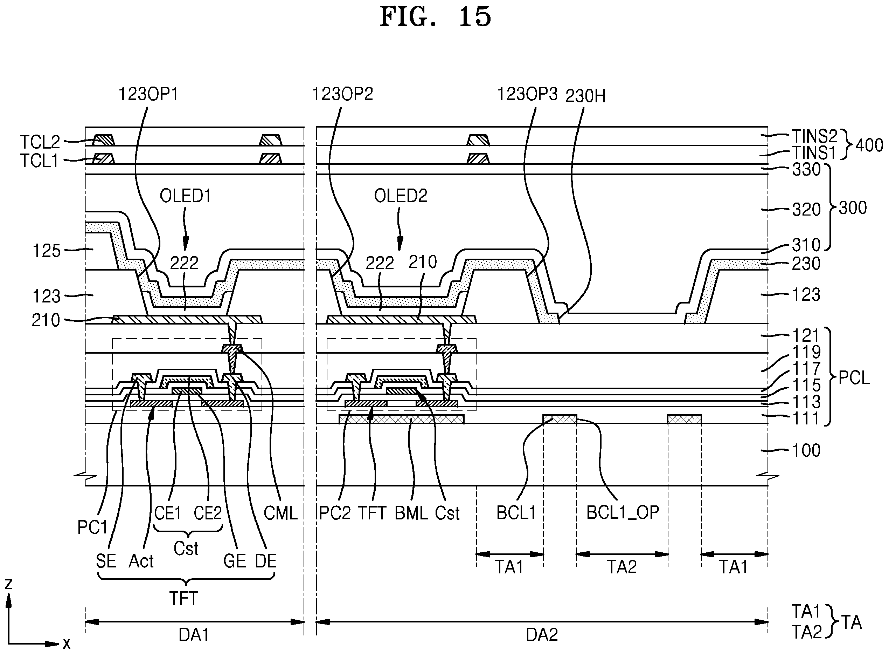

Referring to FIG. 15, a display panel according to an embodiment may include the substrate 100, the counter electrode 230 integrally provided over the first organic light-emitting diode OLED1 that is a first display element and the second organic light-emitting diode OLED2 that is a second display element and including the transmission hole 230H, and the first metal layer BCL1 as a blocking layer at least partially overlapping an edge of the transmission hole 230H.

In the present embodiment, the pixel-defining film 123 may include a third opening 123OP3 disposed in an area corresponding to the second transmission area TA2. As the third opening 123OP3 is formed, a light transmittance of the second transmission area TA2 may be further improved. The third opening 123OP3 of the pixel-defining film 123 may be formed in an area corresponding to the transmission hole 230H of the counter electrode 230.

The area of the third opening 123OP3 may be greater than the area of the transmission hole 230H of the counter electrode 230. In this case, the edge of the transmission hole 230H of the counter electrode 230 may be located inside the third opening 123OP. However, the disclosure is not limited thereto. The area of the third opening 123OP may be less than the area of the transmission hole 230H of the counter electrode 230 so that the edge of the transmission hole 230H is covered by the pixel-defining film 123.

In the second display area DA2, an opening corresponding to the transmission area TA may also be formed in insulating layers other than the pixel-defining film 123, for example, the gate insulating layer 113, the first interlayer insulating layer 115, the second interlayer insulating layer 117, the first organic insulating layer 119, and the second organic insulating layer 121.

In the display panel and the display apparatus according to embodiments, because the counter electrode 230 includes the transmission hole 230H corresponding to the second display area DA2 and a metal layer provided as a blocking layer may be located along an edge of the transmission hole 230H, thereby minimizing asymmetric diffraction.

As described above, in a display panel and a display apparatus according to embodiments, because a counter electrode includes a transmission hole corresponding to a second display area, a transmittance may be improved, and because a blocking layer is located along an edge of the transmission hole, asymmetric diffraction may be minimized.

Embodiments are set out in the following clauses:
Clause 1. A display panel comprising:
   a substrate comprising a first display area and a second display area, the second display area comprising a transmission area;
   first display elements located in the first display area;
   second display areas located in the second display area;
   a counter electrode integrally provided over the first display elements and the second display elements, the counter electrode comprising at least one transmission hole corresponding to the transmission area; and
   a blocking layer at least partially overlapping an edge of the at least one transmission hole.
Clause 2. The display panel of claim 1, further comprising:
   a pixel circuit layer located on the substrate, and comprising first pixel circuits configured to respectively drive the first display elements and second pixel circuits configured to respectively drive the second display elements; and
   a bottom metal layer located between the substrate and the pixel circuit layer and overlapping at least one thin-film transistor included in the second pixel circuits,
   wherein the blocking layer and the bottom metal layer are formed of a same material and are located on a same layer.
Clause 3. The display panel of claim 2, wherein the blocking layer is provided in a closed shape overlapping the entire edge of the at least one transmission hole and comprising an opening through which a central portion of the at least one transmission hole is exposed.
Clause 4. The display panel of claim 1, further comprising a pixel circuit layer located on the substrate, and comprising first pixel circuits configured to respectively drive the first display elements and second pixel circuits configured to respectively drive the second display elements,
   wherein the blocking layer is provided as a part of a wiring included in the pixel circuit layer.
Clause 5. The display panel of claim 4, wherein the wiring is formed so that a portion overlapping the second pixel circuits has a first width and a portion corresponding to the blocking layer has a second width greater than the first width.
Clause 6. The display panel of claim 4, wherein the blocking layer is provided as a part of a data line configured to supply a data signal to the second pixel circuits.
Clause 7. The display panel of claim 1, further comprising:
   a thin-film encapsulation layer covering the first display elements and the second display elements; and
   an input sensing layer located on the thin-film encapsulation layer,
   wherein the blocking layer and a metal layer included in the input sensing layer are formed of a same material and are located on a same layer.
Clause 8. A display panel comprising:
   a substrate comprising a first display area in which first display elements are located and a second display area in which second display elements and a transmission area are located;
   a pixel circuit layer located on the substrate, and comprising first pixel circuits configured to respectively drive the first display elements and second pixel circuits configured to respectively drive the second display elements;
   a bottom metal layer located between the substrate and the pixel circuit layer and at least partially overlapping the pixel circuit layer;
   the first display elements and the second display elements located on the pixel circuit layer and over which a counter electrode is integrally provided;
   a thin-film encapsulation layer covering the first display elements and the second display elements; and
   an input sensing layer located on the thin-film encapsulation layer,
   wherein the counter electrode comprises at least one transmission hole corresponding to the transmission area,
   wherein at least one of a first metal layer located on a same layer as the bottom metal layer, a second metal layer included in the pixel circuit layer, and a third metal layer included in the input sensing layer at least partially overlaps an edge of the at least one transmission hole in a plan view.
Clause 9. The display panel of claim 8, wherein the first metal layer is provided in a closed shape overlapping the entire edge of the at least one transmission hole and comprising an opening through which a central portion of the at least one transmission hole is exposed.
Clause 10. The display panel of claim 8, wherein the second metal layer is located on a same layer as one electrode of a thin-film transistor included in the second pixel circuits.
Clause 11. The display panel of claim 8, wherein the input sensing layer has a structure in which a first touch conductive layer, a first touch insulating layer, a second touch conductive layer, and a second touch insulating layer are sequentially stacked,
   wherein the third metal layer is located on a same layer as the first touch conductive layer or the second touch conductive layer.
Clause 12. The display panel of claim 8, wherein at least two of the first metal layer, the second metal layer, and the third metal layer at least partially overlap the edge of the at least one transmission hole in a plan view.
Clause 13. The display panel of claim 8, wherein a pixel-defining film defining emission areas of the first display elements and the second display elements comprises an opening corresponding to the transmission area.
Clause 14. The display panel of claim 8, wherein the at least one transmission hole is provided in a triangular shape with rounded corners in a plan view.
Clause 15. The display panel of claim 8, wherein the transmission area comprises a first transmission area corresponding to a body portion of the counter electrode and a second transmission area corresponding to the at least one transmission hole of the counter electrode, wherein a light transmittance of the second transmission area is higher than a light transmittance of the first transmission area.
Clause 16. A display apparatus comprising:
   a display panel comprising a first display area and a second display area, the second display area comprising a transmission area; and
   a component located on a bottom surface of the display panel and overlapping the second display area,
   wherein the display panel comprises:
      a substrate;
      first display elements located in the first display area;
      second display elements located in the second display area;
      a counter electrode integrally provided over the first display elements and the second display elements and comprising at least one transmission hole corresponding to the transmission area; and
      a blocking layer at least partially overlapping an edge of the at least one transmission hole.
Clause 17. The display apparatus of claim 16, further comprising:
   a pixel circuit layer located on the substrate, and comprising first pixel circuits configured to respectively drive the first display elements and second pixel circuits configured to respectively drive the second display elements; and
   a bottom metal layer located between the substrate and the pixel circuit layer and overlapping at least one thin-film transistor included in the second pixel circuits,
   wherein the blocking layer and the bottom metal layer are formed of a same material and are located on a same layer.
Clause 18. The display apparatus of claim 16, further comprising
   a pixel circuit layer located on the substrate, and comprising first pixel circuits configured to respectively drive the first display elements and second pixel circuits configured to respectively drive the second display elements, wherein the blocking layer is provided as a part of a wiring included in the pixel circuit layer.
Clause 19. The display apparatus of claim 16, further comprising:
   a thin-film encapsulation layer covering the first display elements and the second display elements; and
   an input sensing layer located on the thin-film encapsulation layer,
   wherein the blocking layer and a metal layer included in the input sensing layer are formed of a same material and are located on a same layer.
Clause 20. The display apparatus of claim 16, wherein the blocking layer is provided in a closed shape overlapping the entire edge of the at least one transmission hole and comprising an opening through which a central portion of the at least one transmission hole is exposed.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by one of ordinary skill in the art that various changes in form and details may be made therein without departing from the scope as defined by the following claims.

## Claims

1. A display panel comprising:
a substrate comprising a first display area and a second display area, the second display area including a transmission area;
first display elements located in the first display area and second display elements located in the second display area, the first display elements and the second display elements including a counter electrode integrally provided over the first display area and the second display area and including at least one transmission hole located in an area corresponding to the transmission area; and
a blocking layer at least partially overlapping an edge of the at least one transmission hole.

2. A display panel comprising:
a substrate comprising a first display area in which first display elements are located and a second display area in which second display elements and a transmission area are located;
a pixel circuit layer located on the substrate and including first pixel circuits located in the first display area and connected to the first display elements and second pixel circuits located in the second display area and connected to the second display elements; a bottom metal layer located between the substrate and the pixel circuit layer and at least partially overlapping the pixel circuit layer;
a thin-film encapsulation layer covering the first display elements and the second display elements; and
an input sensing layer located on the thin-film encapsulation layer,
wherein the first display elements and the second display elements include a counter electrode, the counter electrode including at least one transmission hole located in an area corresponding to the transmission area,
wherein at least one of a first metal layer located on a same layer as the bottom metal layer, a second metal layer included in the pixel circuit layer, and a third metal layer included in the input sensing layer at least partially overlaps an edge of the at least one transmission hole in a plan view.

3. The display panel of claim 2, wherein the first metal layer is provided in a closed shape overlapping the entire edge of the at least one transmission hole and comprising an opening through which a central portion of the at least one transmission hole is exposed.

4. The display panel of claim 2 or claim 3, wherein the second metal layer is located on a same layer as one electrode of a thin-film transistor included in the second pixel circuits.

5. The display panel of claim 2, claim 3 or claim 4, wherein the input sensing layer has a structure in which a first touch conductive layer, a first touch insulating layer, a second touch conductive layer, and a second touch insulating layer are sequentially stacked,
wherein the third metal layer is located on a same layer as the first touch conductive layer or the second touch conductive layer.

6. The display panel of any one of claims 2 to 5, wherein at least two of the first metal layer, the second metal layer, and the third metal layer at least partially overlap the edge of the at least one transmission hole in a plan view.

7. The display panel of any one of claims 2 to 6, wherein a pixel-defining film defining emission areas of the first display elements and the second display elements comprises an opening located in an area corresponding to the transmission area.

8. The display panel of any one of claims 2 to 7, wherein the at least one transmission hole is provided in a triangular shape with rounded corners in a plan view.

9. The display panel of any one of claims 2 to 8, wherein the transmission area comprises a first transmission area corresponding to a body portion of the counter electrode and a second transmission area corresponding to the at least one transmission hole of the counter electrode, and
wherein a light transmittance of the second transmission area is higher than a light transmittance of the first transmission area.

10. A display apparatus comprising:
a display panel comprising a first display area and a second display area, the second display area including a transmission area; and
a component located on a bottom surface of the display panel and overlapping the second display area,
wherein the display panel comprises:
a substrate;
first display elements located in the first display area and second display elements located in the second display area, the first display elements and the second display elements including a counter electrode integrally provided over the first display area and the second display area and including at least one transmission hole located in an area corresponding to the transmission area; and
a blocking layer at least partially overlapping an edge of the at least one transmission hole.

11. The display panel of claim 1 or the display apparatus of claim 10, further comprising:
a pixel circuit layer located on the substrate and including first pixel circuits respectively connected to the first display elements and second pixel circuits respectively connected to the second display elements; and
a bottom metal layer located between the substrate and the pixel circuit layer and overlapping at least one thin-film transistor included in the second pixel circuits,
wherein the blocking layer and the bottom metal layer are formed of a same material and are located on a same layer.

12. The display panel of claim 1 or claim 11 or the display apparatus of claim 10 or claim 11, further comprising a pixel circuit layer located on the substrate and including first pixel circuits connected to the first display elements and second pixel circuits connected to the second display elements,
wherein the blocking layer is provided as a part of a wiring included in the pixel circuit layer.

13. The display panel or display apparatus of claim 12, wherein a portion of the wiring constituting a blocking layer has a width greater than that of another portion of the wiring.

14. The display panel or display apparatus of claim 13 or claim 14, wherein the blocking layer is a part of a data line configured to supply a data signal to one of the second pixel circuits.

15. The display panel or display apparatus of any one of claims 1 or 10 to 14, further comprising:
a thin-film encapsulation layer covering the first display elements and the second display elements; and
an input sensing layer located on the thin-film encapsulation layer,
wherein the blocking layer and a metal layer included in the input sensing layer are formed of a same material and are located on a same layer.

16. The display panel or display apparatus of any one of claims 1 or 10 to 15, wherein the blocking layer is provided in a closed shape overlapping the entire edge of the at least one transmission hole and including an opening through which a central portion of the at least one transmission hole is exposed.
